Europäisches Patentamt

European Patent Office

Office européen des brevets

(19)

(11) Veröffentlichungsnummer: **0 116 148**
**B1**

(12) **EUROPÄISCHE PATENTSCHRIFT**

(45) Veröffentlichungstag der Patentschrift: **14.03.90**

(51) Int. Cl.⁵: **G 06 K 19/06**

(21) Anmeldenummer: **83112496.1**

(22) Anmeldetag: **12.12.83**

(54) **Ausweiskarte mit integriertem Schaltkreis.**

(30) Priorität: **28.12.82 DE 3248385**

(43) Veröffentlichungstag der Anmeldung:
**22.08.84 Patentblatt 84/34**

(45) Bekanntmachung des Hinweises auf die
Patenterteilung:
**14.03.90 Patentblatt 90/11**

(84) Benannte Vertragsstaaten:
**AT BE CH DE FR GB IT LI LU NL SE**

(56) Entgegenhaltungen:
**EP-A-0 019 280**
**EP-A-0 071 255**
**DE-A-2 734 439**
**FR-A-2 483 128**
**FR-A-2 520 541**
**GB-A-2 081 974**

(73) Patentinhaber: **GAO Gesellschaft für
Automation und Organisation mbH
Euckenstrasse 12
D-8000 München 70 (DE)**

(72) Erfinder: **Hoppe, Joachim
Breisacherstrasse 1
D-8000 München 80 (DE)**

(74) Vertreter: **Klunker, Hans-Friedrich, Dr. et al
Patentanwälte Klunker . Schmitt-Nilson . Hirsch
Winzererstrasse 106
D-8000 München 40 (DE)**

Courier Press, Leamington Spa, England.

EP 0 116 148 B1

## Beschreibung

Die Erfindung betrifft eine mehrschichtige Ausweiskarte mit einem unter Wärme und Druck im Preßverfahren hergestellten Schichtaufbau und mit einem auf einem Trägerelement angeordneten IC-Baustein, bei dem das Trägerelement in vorbereitete Aussparungen der Schichten eingesetzt ist und wobei ein im Bereich des IC-Bausteins in den Aussparungen verbleibender Hohlraum mit elastischem Material gefüllt ist. Die Erfindung betrifft weiterhin ein Verfahren zur Herstellung einer solchen Ausweiskarte.

Eine Ausweiskarte, bei der der integrierte Schaltkreisin einem Hohlraum der Karte teilweise von einer federnden Einbettmasse umgeben ist, wird beispielsweise in der DE—OS 22 20 721 beschrieben. Der Schaltkreis ist bei dieser bekannten Karte lediglich an drei Seiten von einer elastischen Masse umgeben, während die Leiterbahnen und die Verbindungspunkte der Leiterbahnen mit dem Schaltkreis starr im Kartenkörper fixiert sind. Bei Verbiegungen der Karte sind daher gerade die Anschlußpunkte der Leiterbahnen zum Schaltkreis stark gefährdet. Zur Herstellung der Ausweiskarte wird in der DE—OS 22 20 721 ausgeführt, daß die Einbettung des Schaltkreises beispielsweise durch das bei der Herstellung der Karte verwendete Polyvinylchlorid vorgenommen werden kann. Im Vergleich zu den empfindlichen Bauteilen, die eingebettet werden sollen, ist PVC vergleichsweise hart, so daß in diesem Fall eigentlich nicht von einer "federnden Einbettung" gesprochen werden kann.

Eine andere Ausweistkarte mit integriertem Schaltkreis und ein Verfahren zu dessen Herstellung ist aus der DE—OS 30 29 939 bekannt. Bei dieser Ausweiskarte sind beispielsweise im noch nicht laminierten Kartenverbund sogenannte Pufferzonen in Form von Zwischenschichten vorgesehen. Diese Schichten haben eine gegenüber den üblicherweise bei der Kartenherstellung verwendeten Folien niedrigere Erweichungstemperatur und sind im Kaltzustand elastisch. Noch bevor der volle Kaschierdruck für das Trägerelement bzw. für den IC-Baustein wirksam wird, erweichen die Schichten niedrigerer Erweichungstemperatur und füllen die im Bereich des Trägerelements vorhandenen Hohlräume. Dadurch bildet sich eine homogene Ummantelung des Trägerelements, welches daraufhin den vollen Kaschierdruck aufnehmen kann.

Bei der in der DE—OS 30 29 939 vorgeschlagenen Ausweiskarte werden im Bereich des Trägerelements vorhandene Hohlräume während bzw. in der Anfangsphase des Kaschierprozesses mit dem Material erweichender, zusätzlich im Laminat vorhandener Kartenschichten ausgefüllt. Das heißt, daß zur Herstellung der Ausweiskarten Zwischenschichten in Form von zusätzlichen Folien oder Beschichtungen verwendet werden müssen, die bei entsprechend niedrigen Kaschiertemperaturen erweichen, den Verbund der Karternschichten untereinander aber möglichst nicht beeinflussen dürfen.

Die Aufgabe der Erfindung besteht darin, eine Ausweistkarte mit eingelagertem integrierten Schaltkreis, sowie ein Verfahren zu deren Herstellung vorzuschlagen, bei dem die sensiblen Anschlüsse der Leiterbahnen an den IC-Baustein geschützt sind, so daß der IC-Baustein funktionssicher eingebaut ist und daß für die Ausweiskarte keine Zusatzfolien oder Beschichtungen verwendet werden müssen, die eine niedrigere Erweichungstemperatur als die übrigen Kartenschichten haben, die aber einen Verbund der übrigen Kartenschichten nicht nachteilig beeinflussen dürfen.

Die Aufgabe wird durch die in den Ansprüchen angegebenen Merkmale gelöst.

Ein Ziel der Erfindung ist es, für die Einbettung des integrierten Schaltkreises bzw. des Trägerelements ein Material zu verwenden, dessen Eigenschaften sowohl den Anforderungen bei der Kartenherstellung als auch denen bei der Benutzung der Karte genügen.

Vor dem Kaschieren werden die im Bereich des Trägerelements bzw. des IC-Bausteins vorhandenen Hohlräume, die sich durch entsprechende Aussparungen im Kartenaufbau ergeben, mit einem pastös bis flüssig eingestellten Material gefüllt. In dem sich anschließenden Kaschiervorgang breitet sich das Material aufgrund seiner geringen Viskosität in alle vorhandenen, unter Umständen auch sehr kleinen Hohlräume lückenlos aus. Dies geschieht schon in der Anfangsphase des Kaschierprozesses, bei dem die Kartenschichten praktisch noch nicht erwärmt sind. Im weiteren Verlauf des Prozesses, in dem die Kartenschichten erweichen und der maximale Kaschierdruck wirksam wird, schützt die lückenlose Ummantelung die mechanisch empfindlichen Bereiche des Trägerelements. Da das die Ummantelung bildende Material außerdem nahezu inkompressibel ist, bleibt der durch die Aussparung der Kartenschichten vorgegebene Hohlraum in seiner Form erhalten, so daß das vergleichsweise harte Kartenmaterial die gefährdeten Teile des Trägerelementes nicht beschädigen kann.

Auch die Deckfolien zeigen im Bereich des Trägerelements keinerlei Einbrüche oder Deformationen, weil das den Hohlraum füllende Material aufgrund seiner Konsistenz einen Druckausgleich schafft. Abhängig von den Eigenschaften des Materials und von der Kaschiertemperatur läuft der Vernetzungs- bzw. Aushärteprozeß ab, durch den das Material schon während oder nach dem Kaschierprozeß in den elastischen Zustand überführt wird. Das nun nachgiebige, stark dehnbare Material bietet einen sehr guten Schutz für das Trägerelement bzw. den IC-Baustein im täglichen Gebrauch der Ausweiskarte.

Bei der Ausweiskarte gemäß der Erfindung sind zum Einbau eines Trägerelements bzw. eines IC-Bausteins keine speziellen zusätzlichen Folien oder Schichtaufbauten und niedriger Erweichungstemperatur notwendig.

Gemäß der Erfindung sind im Bereich des IC-Bausteins bzw. des Trägerelements in der Karte Hohlräume vorhenden, die in jedem Fall mit dem flüssigen bzw. pastösen Material gefüllt werden, während weitere Hohlräume vorgesehen sind, in die ein gegebenenfalls vorhandener Materialüberschluß ausweichen kann. Bei der Erfindung ist sichergestellt, daß bestimmte, für die Funktion der Karte wichtige Hohlräume mit dem sowohl bei der Herstellung als auch bei der Benutzung der Karte schützenden Material gefüllt werden. Sollte ein Materialüberschuß vorhanden sein, wird dieser in Bereiche der Karte verdrängt, die für den sicheren Einbau eines IC-Bausteins ohne Bedeutung sind.

Weitere Vorteile sowie Weiterbildungen der Erfindung ergeben sich aus den Unteransprüchen und aus den nachfolgend beschriebenen Ausführungsformen.

Darin zeigen:

Fig. 1 eine Ausweiskarte mit einem IC-Baustein auf einem Trägerelement,

Fig. 2 die Einzelelemente des bei der Ausweistkarte in Fig. 1 verwendeten Trägerelements,

Fig. 3 die Einzelelemente des Trägerelements aus Fig. 2 in zusammengesetzter Form,

Figs. 4, 5, 6 das Verfahren zur Herstellung der neuen Karten in drei Ablaufphasen,

Fig. 7 eine Ausweistkarte mit einer Zusatzfolie zur Bildung eines Ausgleichraums,

Fig. 8 die Ausweiskarte aus Fig. 7 in der Aufsicht und

Fig. 9 eine Ausweiskarte mit Sperrfolie.

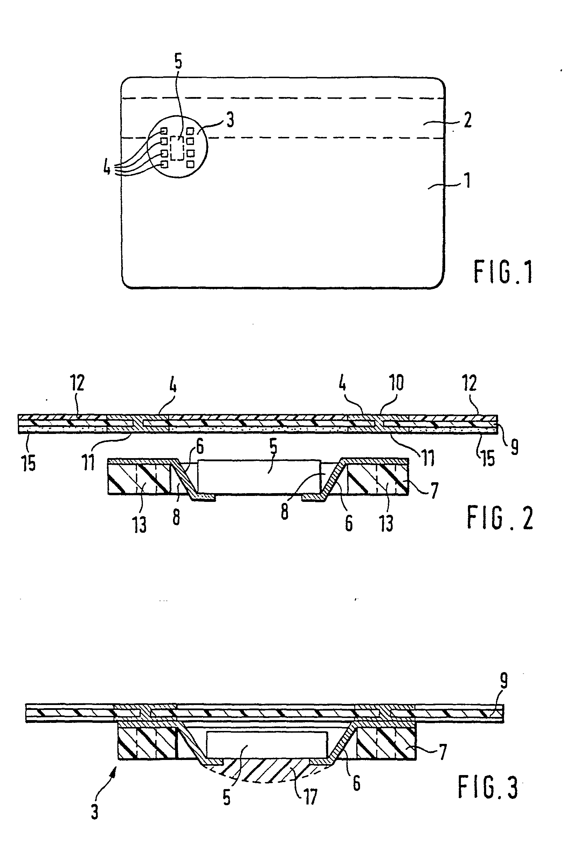

Die Fig. 1 zeigt eine gemäß der Erfindung hergestellte Ausweiskarte 1 mit einem IC-Baustein 5. Der Baustein 5 ist auf einem Trägerelement 3 angeordnet, das weiter unten genauer beschrieben wird. Auf der Oberfläche des Trägerelements sind Kontaktflächen 4 vorgesehen, die die Kommunikation mit dem IC-Baustein ermöglichen. Die Karte kann auf der rückwärtigen Seite zusätzlich mit einem Magnetstreifen 2 ausgestattet sein.

Bei der in der Fig. 1 gewählten Anordnung der Elemente liegen IC-Baustein 5 bzw. Trägerelement 3 und Magnetstreifen 2 im gleichen Kartenbereich. Diese Anordung ist dann vorteilhaft, wenn die unterhalb des Magnetstreifens verbleibende Kartenfläche in vollen Umfang für Prägezeichen reserviert werden soll. Gerade bei Ausweiskarten mit Magnetstreifen und der in Fig. 1 gezeigten Anordnung der Elemente ist der Einbau eines Trägerelements insofern kritisch, weil die Einlagerung eines Trägerelements der genannten Art Inhomogenitäten im Verbund der Kartenschichten verursacht. Diese Inhomogenitäten sind je nach Einbautechnik mit mehr oder weniger starken Verformungen der Kartenschichten und damit auch der Kartenoberflächen im Bereich des Trägerelements verbunden. Verformungen im Bereich des Magnetstreifens sind jedoch nur innerhalb sehr enger Toleranzen zugelassen, um die notwendig Lesesicherbeit der Streifendaten zu gewährleisten. Wie noch gezeigt wird, liefert das erfindungsgemäße Verfahren auch bezüglichen dieses Problems gute Ergebnisse.

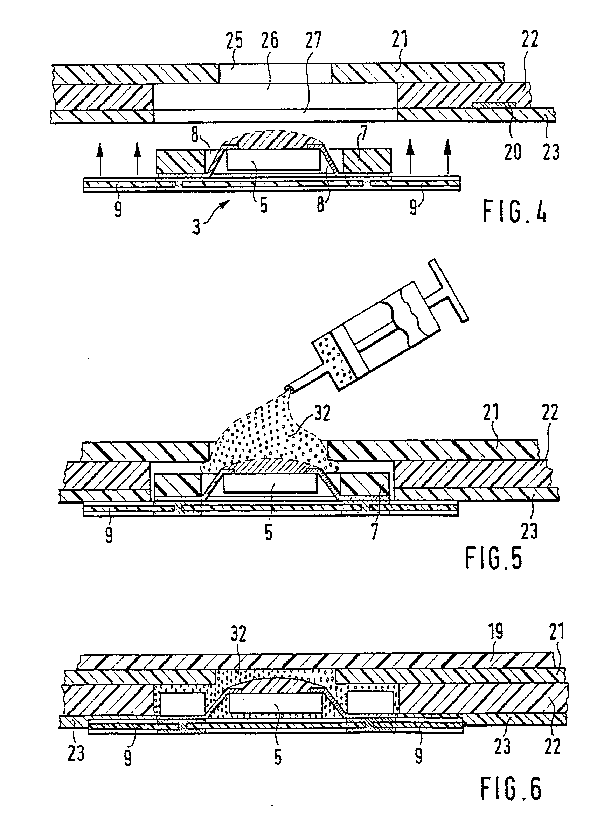

Bevor das neue Verfahren zur Herstellung von Ausweiskarten mit integriertem Schaltkreis näher erläutert wird, soll zunächst der Aufbau des schon erwähnten Trägerelements beschrieben werden. IC-Baustein 5 und Kontaktflächen 4 sind Teile diese Trägerelement 3, wie es in einer Ausführungsform in der Fig. 2 gezeigt ist. Das Trägerelement besteht im wesentlichen aus zwei Folien 7 und 9, die der besseren Übersicht wegen in der Fig. 2 noch getrennt voneinander dargestellt sind. Der IC-Baustein ist in einem Fenster 8 einer ersten Folie 7 angeordnet und hier mit Leiterbahnen 6 verbunden. Die Leiterbahnen enden auf der Folie 7. Diese Art der Kontaktierung von IC-Bausteinen ist bekannt und wird allgemein als "Tape Automated Bonding" bezeichnet. Die zweite Folie 9 trägt die zur Kommunikation mit dem Baustein notwendigen Kontaktflächen 4. Diese Kontaktflächen sind über leitende Kanäle 10 mit weiteren leitenden Flächen 11 verbunden, die bezogen auf die Kontaktflächen 4 auf der gegenüberliegenden Seite der Folie 9 liegen. Die Folie 9, die aus flexiblem Material, beispielsweise Polyimid, besteht, kann auf der Seite der Kontaktflächen 4 partiell eine Lackschicht 12 tragen, die die Dicke der Kontaktflächen egalisiert. Zur Herstellung des Trägerelements werden die Folien 7 bzw. 9 zusammengeführt und die Leiterbahnen 9 der Folie 7 mit den leitenden Flächen 11 der Folie 9 beispielsweise durch einen Lötprozeß miteinander verbunden. Dazu kann die Folie 7 im Bereich der Leiterbahnen mit Aussparungen 13 versehen sein, die die Zufuhr von Wärme an die Lötstellen ermöglichen. Das fertiggestellte Trägerelement 3 zeigt die Fig. 3. Da die Folie 9 mit den üblicherweise bei der Herstellung von Ausweiskarten verwendeten Kartenmaterialien keine Verbindung eingeht, wird auf der Seite der Folie, die später mit dem Kartenmaterial verbunden werden soll, ein Kaschierkleber 15 aufgetragen. Die freiliegende Seite des integrierten Schaltkreises 5 kann noch mit einem Lacktropfen 17 abgedeckt werden, um den Schaltkreis und auch die Kontaktpunkte der Leiterbahnen mit dem Schaltkreis vor mechanischer Beanspruchung zu schützen.

Die Fig. 4, 5 und 6 zeigen anhand eines Ausführungsbeispiels in drei Ablaufphasen die Herstellung von Ausweiskarten mit integriertem Schaltkreis. In den Fig. ist jeweils nur der in diesem Zusammenhang interessierende Kartenausschnitt im Bereich des Trägerelements gezeigt.

Zunächst werden die Folien 21, 22 und 23 mit den vorbereiteten Aussparungen 25, 26 und 27 zusammengestellt. Während die Aussparungen 26, 27 etwa den Abmaßen der Folie 7 des Trägerelements 3 angepaßt sind, entspricht die Aussparung 25 etwa der Größe des Fensters 8 der Folie 7, in dem der integrierte Schaltkreis angeordnet ist. Die Folie 22 kann ein- oder beidseitig mit einem Druckbild 20 versehen sein, das zum Schutz mit einer transparenten Folie, in diesem Beispiel die Folie 23, abgedeckt ist. In den in Fig. 4 gezeigten Schichtaufbau wird zunächst das Trägerelement 3 lagerichtig eingesetzt. Anschließend wird in diesem Ausführungsbeispiel die Folie 9 des Trägerelements im Randbereich, beispielsweise mit Hilfe einer Schweißeinrichtung, rundum mit der Folie 23 der Schichtenfolge verbunden, um die Position des Trägerelements für die nachfolgenden Verfahrensgänge zu fixieren. Wie man der Darstellung in Fig. 5 entnehmen kann, sind die einzelnen Schichtdicken so gewählt, daß sich zwischen der Folie 7 des Trägerelements und der sich anschließenden Folie 21 Freiräume ergeben.

In einem nachfolgenden Arbeitsgang werden die auch nach dem Einbau des Trägerelements in der Schichtfolge noch verbleibenden Hohlräume mit eine dosierten Menge flüssig bis pastös eingestellten Materials 32 gefüllt (Fig. 5).

Ein gemäß der Erfindung geeignetes Material ist beispielsweise das unter dem Namen "Sylgard 186 Elastomer" (Firma Dow Corning) bekannt gewordene Silikonkautschuk. Es handelt sich um ein gießbares Zweikomponentenmaterial mittlerer Viskosität, das nach dem Mischen der Komponenten je nach Wärmeeinwirkung mehr oder weniger schnell zu einer festen gummiartigen Masse vernetzt. Je nach Einstellung der Viskosität werden die im Bereich des Trägerelements vorhandenen Hohlräume abhängig von ihrer Größe und Zugängigkeit schon vor der Kaschierung ganz oder auch nur teilweise ausgefüllt.

Der entsprechend der Fig. 5 vorbereitete und mit Silikon gefüllte Schichtaufbau wird nun, nachdem er auf der dem Trägerelement gegenüberliegenden offenen Seite mit einer weiteren Folie 19 abgedeckt worden ist, unter Anwendung von Wärme und Druck zusammengepreßt.

In der Anfangsphase des Prozesses dringt das niedrigviskose material durch das Zusammenpressen der Schichten nun in alle im Bereich des Trägerelements vorhandene Hohlräume und füllt diese, auch wenn sie nur über sehr enge Kanäle zugängig sind, lückenlos aus. Da die Folie 9 des Trägerelements 3 mit der Folie 23 des Schichtaufbaus rundum verschweißt ist, kann das noch flüssige Silikon zur Seite des Trägerelements hin nicht aus dem Schichtaufbau austreten. Noch bevor die Kartenschichten erweichen, hat das flüssige Material bereits das Trägerelement und den integrierten Schaltkreis ummantelt. Im weiteren Verlauf des Kaschierprozesses, in dem die erweichenden Kartenschichten auf die endgültige Kartenstärke gepreßt werden, verhindert das Silikon eine Beschädigung der empfindlichen Teile des Trägerelements und schafft gleichzeitig aufgrund seiner jetzt noch vorhandenen inkompressiblen Konsistenz einen Druckausgleich. Dieser sorgt dafür, daß die ursprünglichen Aussparungen der Kartenschichten nahezu erhalten bleiben und daß die Folienschichten insgesamt in ihrer Form stabilisiert werden. Einbrüche und Vertiefungen vor allem auch an der Oberfläche der Folie 19 werden vermieden. Es ist daher auch möglich, den Magnetstreifen einer Karte im Bereich des Trägerelements anzuordnen, ohne daß die für Magnetstreifen zulässigen Unebenheiten überschritten werden.

In der Fig. 6 ist die fertiggestellte Ausweiskarte mit eingebettetem Trägerelement gezeigt. Je nach den Eigenschaften des Füllmaterials und den Bedingungen beim Zusammenpressen der Schichten vernetzt das ursprünglich flüssige Material nach entsprechender Zeit zu einer festen, elastischen Masse. Aufgrund dieser Eigenschaft ist das so elastisch ummantelte Trägerelement mit seinen empfindlichen Bauteilen auch während der Benutzung der Karte im täglichen Gebrauch optimal geschützt.

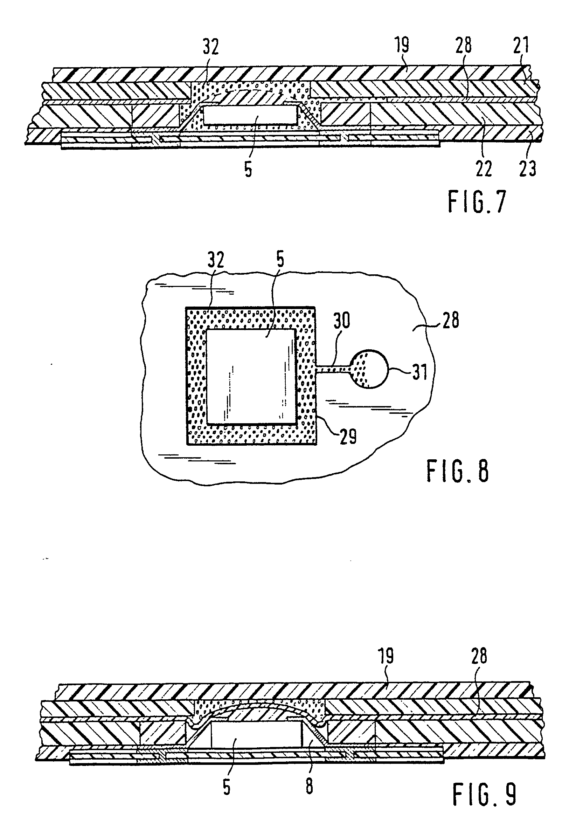

Wie schon erwähnt, ist die Menge des Füllmaterials so dosiert, daß die vorhandenen Hohlräume im Bereich des Trägerelements vollständig ausgefüllt werden. Da aufgrund von Fertigungstoleranzen der Einzelelemente das Volumen aller Hohlräume von Karte zu Karte variiert, ist die vollständige Füllung aller Hohlräume nur gewährleistet, wenn vor dem Kaschieren ein Überschuß an Material zur Füllung der Hohlräume verwendet wird. Für diesen Materialüberschuß müssen gezielt Hohlräume vergesehen werden, die je nach Materialmenge ganz oder auch nur teilweise gefüllt werden. Dazu ist, wie in der Fig. 7 gezeigt, im Schichtaufbau der Karte eine weitere Folie 28 vorgesehen, die zwischen den Folien 21, 22 der zuvor beschriebenen Schichtaufbauten angeordnet ist. Aus der in Fig. 8 gezeigten Aufsicht ist zu erkennen, daß die zusätzliche Folie eine Ausstanzung aufweist, bei der ein dem Schaltkreis 5 angepaßtes Stanzloch 29 über einen Kanal 30 mit einem zweiten, in diesem Ausführungsbeispiel kreisrunden, Stanzloch 31 verbunden ist. Zwischen den Folien 21, 22 angeordnet, wird das Stanzloch 31 zu einem Ausgleichsraum, in den gegebenenfalls überschüssiges Material eindringen kann. Der Kanal 30 zur Aussparung 31 ist in seinem Querschnitt derart ge daß er erste dann Einbettmaterial durchfließen läßt, wenn die übrigen Hohlräume im Bereich des Trägerelements gefüllt sind.

In der Fig. 9 ist ein weiteres Ausführungsbeispiel gezeigt, wobei die zusätzliche Sperrfolie 28 keine Ausstanzungen aufweist. Je nach der Menge des überschüssigen Materials wird die Folie mehr oder weniger weit in die Aussparung 8 gedrückt. Bei Verwendung einer geschlossenen Folie wird das zur Einbettung des Schaltkreises gewählte Material vom Schaltkreis selbst ferngehalten. Es ist daher möglich, bei dieser Anwendung Materialien einzusetzen, die mit dem Schaltkreis oder mit den Leiterbahnen nicht in Berührung kommen dürfen, beispielsweise elektrisch leitende oder chemisch aggressive Stoffe. Der Raum zwischen der Folie 19 und der Sperrfolie 28 ist in jedem Fall vollständig mit dem elastischen Einbettmaterial gefüllt, während der Raum, in dem sich der Schaltkreis befindet, je nach Materialüberschuß gefüllt wird. Die Sperrfolie 28 hat neben der beschriebenen Wirkung auch die Funktion, das zunächst flüssige Polymer an einem Durchtritt auf die andere Kartenseite bzw. am Auslaufen aus dem Kartenaufbau zu hindern. Die Sperrfolie wirkt in diesem Fall wie eine zusätzliche Dichtung, die den Innenraum hermetisch abschließt.

Während des Kaschiervorgangs wird die Sperrfolie 28 unter Umständen stark gedehnt, was bei entsprechend dünnen Folien ohne Probleme möglich ist.

**Patentansprüche**

1. Mehrschichtige Ausweiskarte (1) mit einem unter Wärme und Druck im Preßverfahren hergestellten Schichtaufbau und mit einem auf einem Trägerelement (3) angeordneten IC-Baustein (5), bei dem das Trägerelement in vorbereitete Aussparungen (25, 26, 27) der Schichten eingesetzt ist und wobei ein im Bereich des IC-Bausteins (5) in den Aussparungen verbleibender Hohlraum mit elastischem Material (32) gefüllt ist, dadurch gekennzeichnet, daß als elastisches Material (32) ein Polymer dient, das in pastöser bis flüssiger Form ver dem endgültigen Zusammenlegen der Schichten in den Hohlräum einfüllbar und durch die Wärmeeinwirkung während des Verpressens zu einer festen elastischen Masse vernetzbar ist und daß innerhalb der Schichten ein weiterer Hohlraum (31) zur Aufnahme überschüssigen Füllmaterials vorgesehen ist, der mit dem Hohlraum für den IC-Baustein über einen engen Kanal (30) in Verbindung steht.

2. Mehrschichtige Ausweiskarte nach Anspruch 1, dadurch gekennzeichnet, daß der weitere Hohlraum (31) und der Kanal (30) durch Ausstanzungen in einer Kartenschicht gebildet sind.

3. Mehrschichtige Ausweiskarte (1) mit einem unter Wärme und Druck im Preßverfahren hergestellten Schichtaufbau und mit einem auf einem Trägerelement (3) angeordneten IC-Baustein (5), bei dem das Trägerelement in vorbereitete Aussparungen (25, 26, 27) der Schichten eingesetzt ist und wobei ein im Bereich des IC-Bausteins (5) in den Aussparungen verbleibender Hohlraum mit elastischem Material (32) gefüllt ist, dadurch gekennzeichnet, daß als elastisches Material (32) ein Polymer dient, das in pastöser bis flüssiger Form ver dem endgültigen Zusammenlegen der Schichten in einen ersten Raum des durch eine Sperrfolie geteilten Hohlraums einfüllbar und durch die Wärmeeinwirkung während des Verpressens zu einer festen elastischen Masse vernetzbar ist, wobei eine Verdrängung des überschüssigen Füllmaterials von dem ersten Raum in einen zweiten, den IC-Baustein enthaltenden, Raum unter Dehnung der Sperrfolie erfolgt.

4. Verfahren zur Herstellung mehrschichtiger Ausweiskarten nach Anspruch 1 oder 2 gekennzeichnet durch die folgenden Schritte:
   a) ver dem Zusammenlegen der einzelnen Schichten werden im Schichtaufbau im Bereich des Trägerelements (5) die vorhandenen Hohlräume mit einem pastös bis flüssig eingestellten Material gefüllt;
   b) die Schichten werden endgültig zusammengelegt und unter Einwirkung von Wärme und Druck verpreßt, wobei
   c) das Material den IC-Baustein umfließt,
   d) nach vollständiger Ausfüllung des Hohlraums (32) im Bereich des IC-Bausteins (5) überschüssiges Material über den Kanal (30) in den weiteren Hohlraum (31) gedrückt wird und
   e) das Material zu einer festen elastischen Masse vernetzt.

5. Verfahren zur Herstellung mehrschichtiger Ausweiskarten nach Anspruch 3 gekennzeichnet durch die folgenden Schritte:
   a) ver dem Zusammenlegen der einzelnen Schichten wird ein im Schichtaufbau im Bereich des Trägerelements (5) oberhalb der Sperrolie vorhandene Raum mit einem pastös bis flüssig eingestellten Material gefüllt;
   b) die Schichten werden unter Einwirkung von Wärme und Druck verpreßt, wobei
   c) das Material unter Dehnung der Sperrfolie in einen zweiten, den IC-Baustein enthaltenden, Raum gedrückt wird und
   d) zu einer festen elastischen Masse vernetzt.

**Revendications**

1. Carte d'indentité multicouche (1) comprenant un assemblage de couches réalisée par un procédé de compression à chaud et sous pression et comprenant une puce à CI (5) montée sur un élément de support (3), l'élément de support étant disposé dans des évidements (25, 26, 27) préparés à l'avance dans les couches et un espace creux subsistant dans les évidements dans la région de la puce à CI (5) étant rempli d'un matériau élastique (32), caractérisé en ce qu'on utilise en tant que matériau élastique (32) un polymère pouvant être introduit sous une forme pâteuse à fluide dans l'espace creux avant l'assemblage définitif des couches et réticulé sous forme d'une masse élastique solide sous l'effet de la chaleur pendant la compression, et en ce qu'un autre espace creux (31) à l'intérieur des couches est en liaison par un étroit canal (30) avec l'espace creux destiné à la puce à CI, qui est prévu pour recevoir le matériau de remplissage en excès.

2. Carte d'identité multicouche selon la revendication 1, caractérisé en ce que l'autre espace creux (31) et le canal (30) sont formés par des découpes dans une couche de la carte.

3. Carte d'indentité multicouche (1) comprenant un assemblage de couches réalisée par un procédé de compression à chaud et sous pression et comprenant une puce à CI (5) montée sur un élément de support (3), l'élément de support étant disposé dans des évidements (25, 26, 27) préparés à l'avance dans les couches et un espace creux subsistant dans les évidements dans la région de la puce à CI (5) étant rempli d'un matériau élastique (32), caractérisée en ce qu'on utilise en tant que matériau élastique (30) un polymère pouvant être introduit sous une forme pâteuse à fluide avant l'assemblage définitif des couches dans une premier espace de l'espace creux subdivisé par une feuille de fermeture, et pouvant être réticulé sous forme d'une masse élastique et solide par application de la chaleur pendant la compression, un refoulement du matériau de remplissage en excès étant ainsi provoqué depuis le premier espace vers un second espace contenant la puce à CI par dilatation de la feuille de fermeture.

4. Procédé pour réaliser des cartes d'identité multicouche selon la revendication 1 ou 2, caractérisé par les étapes suivantes:

a) les espaces creux présents dans l'assemblage de couches dans la région de l'élément de support (5) sont remplis d'un matériau réglé sur une constance pâteuse à fluide avant l'assemblage des couches individuelles;

b) les couches sont finalement assemblées et comprimées à chaud et par pression;

c) le matériau entoure la puce à CI;

d) le matériau en excès après remplissage total de l'espace creux (32) dans la région de la puce à CI (5) est refoulé par le canal (30) dans l'autre espace creux (31); et

e) le matériau est réticulé sous forme d'une masse élastique solide.

5. Procédé pour réaliser des cartes d'identité multicouches selon la revendication 4, caractérisé par les étapes suivantes:

a) avant assemblage des couches individuelles, un espace creux présent dans l'assemblage de couches dans la région de l'espace creux (5) au-dessus de la feuille de fermeture est rempli d'un matériau réglé sur une constance pâteuse à fluide;

b) les couches sont comprimées sous l'effet de chaleur et d'une pression;

c) le matériau étant de ce fait refoulé dans un second espace contenant la puce à CI; et

d) étant réticulé sous forme d'une masse élastique solide.

**Claims**

1. Laminated identity card (1) with a structure of layers produced in a stamping process using heat and pressure and with an IC chip (5) arranged on a carrier element (3), in which the carrier element is inserted in pre-prepared openings (25, 26, 27) in the layers and a cavity which remains in the openings around the IC chip (5) is filled with elastic material (32), characterised in that as the elastic material (32) there serves a polymer which is introduced in a pasty or liquid form into the cavity before the final assembly of the layers and is cross-linked into a solid elastic mass by the action of heat during the pressing operation and that within the layers there is provided a further cavity (31) for receiving excess filling material and communicating through a narrow passage (30) with the cavity for the IC chip.

2. Laminated identity card according to claim 1, characterised in that the further cavity (31) and the passage (30) are formed by stamping out in a layer of the card.

3. Laminated identity card (1) with a structure of layers produced in a stamping process using heat and pressure and with an IC chip (5) arranged on a carrier element (3), in which the carrier element is introduced into pre-prepared openings (25, 26, 27) in the layers and a cavity which remains in the openings around the IC chip (5) is filled with elastic material (32), characterised in that as the elastic material (32) there serves a polymer which is introduced into a first chamber of the cavity separated by a barrier film before the final assembly of the layers and is cross-linked into a solid elastic mass by the action of heat during the pressing operation, a displacement of the excess filling material from the first chamber into a second chamber containing the IC chip taking place with stretching of the barrier film.

4. Process for producing laminated identity cards according to claim 1 or 2 characterised by the following steps:

a) before the assembly together of the individual layers the cavities present in the laminate in the neighbourhood of the carrier element (5) are filled with a pasty or liquid material which is introduced;

b) the layers are then assembled together and pressed together with the action of heat and pressure,

c) the material flowing around the IC chip,

d) after complete filling of the cavity (32) in the neighbourhood of the IC chip (5) excess material is forced through the passage (30) into the further cavity (31) and

e) the material is cross-linked to form a solid elastic mass.

5. Process for producing laminated identity cards according to claim 3, characterised by the following steps:

a) before the individual layers are assembled together a chamber which is present in the assembly of layers in the neighbourhood of the carrier element (5) above the barrier film is filled with a pasty or liquid material introduced;

b) the layers are pressed together with the action of heat and pressure,

c) the material is forced into a second chamber containing the IC chip, the barrier film stretching, and

d) cross-linked to form a solid elastic mass.

FIG.1

FIG.2

FIG.3

FIG.4

FIG.5

FIG.6

FIG.7

FIG.8

FIG.9